# EUROPEAN PATENT APPLICATION

(11) **EP 1 134 791 A2**
(43) Date of publication of application: **19.09.2001**
(21) Application number: 01302440.1
(22) Date of filing: 16.03.2001
(51) Int. Cl.: H01L 21/00

(54) **Shadow ring with common guide member**

(30) Priority: 16.03.2000 US 527090
(71) Applicant: Applied Materials, Inc., Santa Clara, California 95054 (US)
(72) Inventor: Sherstinsky, Semyon, San Francisco, California 94121 (US); Chen, Ling, Sunnyvale, California 94087 (US); Yudovsky, Joseph, Campbell, California 95008 (US); Mahajani, Maitreyee, San Jose, California 95129 (US); Ghanayem, Steve G., Los Altos, California 94024 (US); Augason, Calvin R., Los Altos, California 94024 (US); Zuniga, Leonel A., San Jose, California 95148 (US); Ngo, Tai T., Santa Clara, California 95050 (US)
(74) Representative: Bayliss, Geoffrey Cyril

(57) **Abstract**

This disclosure relates to a process chamber (12) having a common alignment and shielding apparatus is provided for aligning both a substrate (14)on a support member (30) and shadow ring (70) with at least one common guide member (224) at the periphery of the support member. The shadow ring preferably includes a covered recess (324) formed in its lower surface for receiving the common guide member (224) without permitting process gasses to flow therethrough. A method of aligning the substrate and shadow ring is also provided in which the substrate and the shadow ring are both lowered onto the substrate support member and each are adapted to mate with the common guide member.

## Description

In the fabrication of integrated circuits, equipment has been developed to automate substrate processing by performing several sequences of processing steps without removing the substrate from a vacuum environment, thereby reducing transfer times and contamination of substrates. Such a system has been disclosed for example by Maydan et al, U.S. Pat. No. 4,951,601, in which a plurality of processing chambers are connected to a transfer chamber. A robot in a central transfer chamber passes substrates through slit valves in the various connected processing chambers and retrieves them after processing in the chambers is complete.

The processing steps carried out in the vacuum chambers typically require the deposition or etching of multiple metal, dielectric and semiconductor film layers on the surface of a substrate. Examples of such processes include chemical vapor deposition (CVD), physical vapor deposition (PVD), and etching processes.
Vacuum chambers are employed to deposit thin films on substrates. Typically, a precursor gas is charged to a vacuum chamber through a gas manifold plate situated above the substrate, which substrate is heated to process temperatures, generally in the range of about 250 to about 650 °C. The precursor gas reacts on the heated substrate surface to deposit a thin layer thereon.

To increase manufacturing efficiency and device capabilities, the size of devices formed on a substrate has decreased, and the number of devices formed on a substrate has increased in recent years. Also, it is increasingly important that the thin films be of uniform thickness across the substrate so that all of the devices formed on the substrate are uniform. Further still, it is increasingly important that the generation of particles in processing chambers be avoided to reduce contamination of substrates that will reduce the yield of good devices.

In a typical process chamber, a support member on which a substrate is mounted during processing is movable vertically in the chamber. The substrate is brought into the chamber from an external robot blade. A plurality of support fingers are also vertically movable by an elevator and extend through the support member to facilitate transfer of the substrate from the robot blade to the support member. In most CVD processes, the substrate and the support member on which it is supported are typically heated.

Such process chambers may be used to deposit metals, such as tungsten, from WF₆ precursor gas onto the substrate as well as other metals and dielectrics. WF₆ is a highly volatile gas, and problems have arisen because tungsten deposits not only on the top side of the substrate, but also on the edge surfaces and back side of the substrate. These edge and back side surfaces are typically rougher than the highly polished top surface and are not coated with an adhesive layer such as sputtered titanium nitride and, thus, the deposited materials tend to flake off the edge and bottom surfaces of the substrate, thereby contaminating the chamber. Also, material deposited on these surfaces may cause the substrate to adhere to the support member and may compromise the integrity of the devices formed near the edge of the substrate. Additionally, some processes use a barrier film that is, for example, formed of titanium and titanium nitride that covers the entire substrate surface wherein the titanium layer is partially exposed. Often in these processes, a layer of tungsten is deposited on the barrier layer. However, as tungsten is not adhesive to titanium, the tungsten deposited thereon tends to exfoliate therefrom, thereby creating particles.

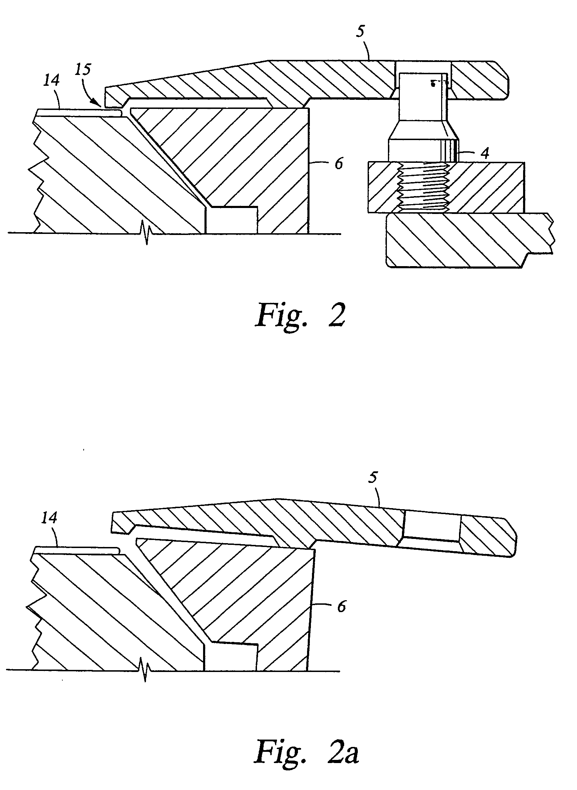

Thus, shadow rings and purge gas have come into use. Shadow rings cover the periphery of the substrate during deposition to mask this area of the substrate, thereby preventing the deposition gases from reaching the edge and back side surfaces of the substrate. However, due to the volatility of WF₆, for example, shadow rings alone do not prevent edge and back side deposition on the substrate. The use of a purge gas directed behind or at the edge of the substrate behind the shadow ring has therefore been used. The purge gas exerts a positive pressure that reduces the likelihood that processing gas will reach these edge and back side surfaces. In systems using a purge gas, the support member typically has a plurality of spaced purge gas orifices extending therethrough that deliver the purge gas to an annular gas groove in the upper surface of the support member. The annular gas groove surrounds the substrate and delivers the gas to the peripheral edge of the substrate. Typically, this gas is delivered to the substrate from below the edge so that it flows around the edge of the substrate and effectively flows over the upper surface of the substrate in a direction perpendicular to the edge of the substrate. Figures 2-3 show examples of such conventional shadow ring configurations.

As the desire for greater throughput and efficiency has increased, the standards governing the thickness and uniformity of the deposited film at the substrate edge have continually become more stringent. Ideally, the deposited film has a uniform thickness across the full area of the substrate with the edges dropping off rapidly so that the zone of exclusion has little or no deposition thereon. Further, there is ideally no deposition on the beveled edges of the substrate. Industry practice has moved toward this ideal goal so that the current industry standards demand no film deposition on the beveled edge of the substrate and a film thickness at a point 3 mm from the edge of the substrate that is 90 percent or more of the film thickness at the center of the substrate with a thickness uniformity of +/- 5 percent, excluding the area within 5 mm from the substrate edge.

One important element in meeting the requirements involves optimization of the purge gas delivery and its flow rate. If the flow of purge gas is too great, the purge gas may prevent or interfere with the deposition of the process gas on the substrate where deposition is desired. As the flow rate rises, the purge gas flows further inward toward the center of the substrate causing greater interference with the process gas flow and its even distribution. Therefore, the interference may cause film uniformity problems near the edge of the substrate as well as further toward the center of the substrate. Accordingly, a high flow rate of purge gas may prevent the process from meeting the uniformity requirements of industry standards. Accordingly, a narrow tolerance zone for the gap between the substrate and the shadow ring is desired to provide a constant low flow gas purge rate. Such a narrow gap tolerance zone may also require stable dimensionality of the shadow ring to provide repeatable performance of the shadow ring.

Another important element in meeting industry requirements is concentricity of the edge exclusion about the wafer. Conventional shadow rings may provide guide pins or other alignment members to align the substrate and the shadow ring. However, typical shadow rings utilize separate alignment members for aligning the shadow ring and the substrate with respect to each other.

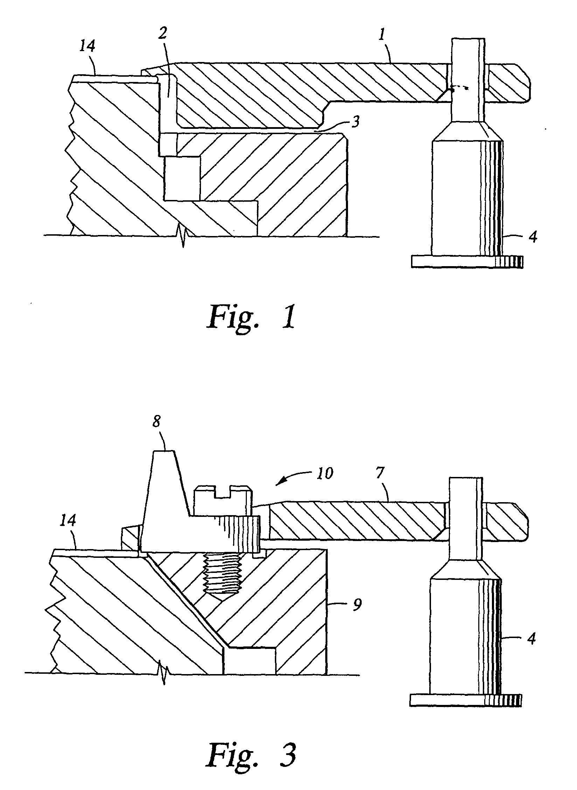

The conventional shadow ring shown in Figure 1 provides direct contact between the shadow ring 1 and the substrate 14, which may cause undue particle generation at the point of contact between the substrate 14 and the shadow ring 1. Additionally, because the shadow ring 1 is designed to directly contact the substrate 14, the purge gas does not flow around the edge of the substrate 14 and over the exclusionary zone. Rather, the purge gas is designed to flow only in the flow annulus 2 below and at the edge of the substrate 14 and then exits the flow annulus through exit port 3 to the process chamber (not shown). In addition to the undesirable particle generation from direct contact with the substrate 14, the configuration shown in Figure 1 also may result in local tungsten deposition on the back side of the substrate 14 as localized gaps may exist between the shadow ring 1 and the substrate 14. In the event that such gaps do occur, the purge gas may undesirably draw down the process gas into the flow annulus 2 and permit deposition to occur on both the edge or lower surface of the substrate 14 near the gap. In addition, no provision is made to concentrically align the substrate 14 with the shadow ring 1. The placement of the shadow ring 1 is maintained by shadow ring guide pins 4. However, the placement of the substrate 14 is maintained independent from the placement of the shadow ring 1. Accordingly, concentricity of the shadow ring 1 with respect to the substrate 14 may not be sufficiently reliable in particular applications.

Figure 2 shows a conventional shadow ring configuration in which the shadow ring 5 does not contact the substrate 14. A purge gap 15 is provided between the substrate 14 and the shadow ring 5 through which the purge gas flows around the lower surface of the substrate 14, over the edge of the substrate 14, and over the upper surface exclusion zone about the periphery of the substrate 14. The shadow ring 5 shown in Figure 2 may have a purge gap 15 of approximately .006 inches between the substrate 14 and the shadow ring 5. The dimensional tolerance of the purge gap, however, may be subject to variation during manufacturing as the tolerances of two distinct parts may affect the dimensional tolerance of the purge gap. Additional gap variation may also occur due to thermal distortion of the purge ring 6 to which the shadow ring 5 is mounted, as shown in Figure 2a.

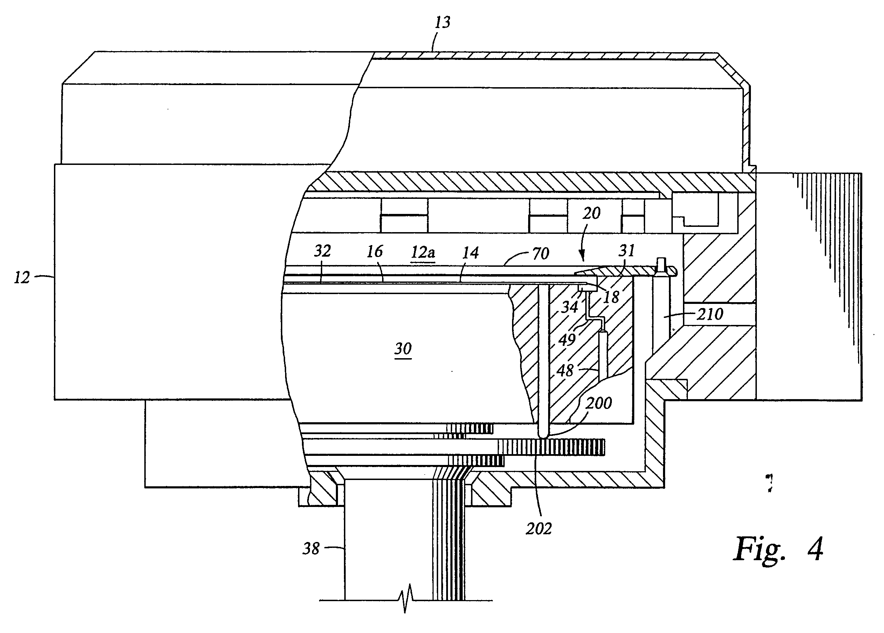

Figure 3 shows a conventional shadow ring configuration in which the lateral alignment of both the substrate 14 and the shadow ring 7 are maintained by common guide pins 8. The substrate position is limited by the front face of the pin 8, and a portion of the shadow ring 7 extends over the pin and its position is limited by the front face of the pin 8. Concentricity of the shadow ring and substrate may therefore be adequate to provide a uniform radial width exclusion zone. However, the shadow ring 7 configuration shown in Figure 3 requires direct contact between the substrate 14 and shadow ring, which may result in undesirable particle generation and also requires exhaust of the purge gas through the gap between the shadow ring 7 and the purge ring 9. Further, to enable the guide pin 8 to align both the substrate and the shadow ring, local cutouts 10 are provided in the shadow ring 7 to allow the guide pins 8 to extend through the cutouts 10. Accordingly, process gasses, such as tungsten, may flow through the cutouts 10 and permit undesirable local deposition on the beveled edge and backside of the substrate 14 proximate the cutouts 10.

Therefore, there is a need to provide a system which provides repeatable concentricity of the substrate with respect to the shadow ring, provides a repeatable purge gap between the shadow ring and the substrate, and has no local cutouts in the shadow ring.

In one aspect, the present invention is directed to an alignment apparatus for concentrically aligning a shadow ring and substrate on a substrate support member in a substrate processing system, comprising: at least one common guide member adapted to receive both an edge of the substrate and a guide enclosure portion of the shadow ring; wherein the guide enclosure portion of the shadow ring is shielded from process gasses directed towards the shadow ring from above the shadow ring. The guide enclosure portions of the shadow ring may include at least one guide member recess formed in the lower surface of the shadow ring. The shadow ring recess may preferably be adapted to receive at least one common guide member therein. Further, the shadow ring may have an aerodynamically shaped upper surface proximate each of the guide enclosure portions, and a continuous purge gap may be maintained between the shadow ring and the substrate during processing. Still further, the purge gap may be maintained by supporting the shadow ring on the substrate support member, and the substrate support member may be of unitary construction.

In another aspect, the present invention may be directed to a substrate alignment and shielding apparatus. The apparatus may comprise: a substrate support member having a substrate support portion machined therein. The substrate support member may have an upper surface formed about the periphery thereof; a shadow ring may be adapted to rest on the upper surface of the substrate support member; and the substrate support member may further have an annular purge gap formed therein. Further, the substrate support member may have at least one common guide member associated therewith; and the substrate support member may be adapted to receive and align both a substrate and the shadow ring. Each of the at least one common guide members may be mounted to the substrate support member, or each of the at least one common guide members may be integral with the substrate support member.

In yet another aspect, the invention provides a method of aligning a substrate and a shadow ring with one another in a substrate process system, comprising: providing a substrate support member having a purge gap formed therein, having a substrate supporting portion defined thereby, and having an upper surface thereon; providing at least one common guide member proximate the purge gap formed in the substrate support member adapted to receive and align both the substrate and the shadow ring; moving the shadow ring and the substrate support toward one another so that the substrate is generally aligned within the common guide members; and causing the shadow ring to rest on the upper surface of the substrate support member while general alignment is maintained between the common guide members and guide member recesses formed in the lower surface of the shadow ring.

In still another aspect, the present invention is directed to a substrate processing system, comprising: a process chamber; and a substrate support member disposed within the process chamber having a substrate support portion machined therein. The substrate support member may have an upper surface formed about the periphery thereof; and a shadow ring may be adapted to rest on the upper surface of the substrate support member. The substrate support member may further have an annular purge gap formed therein; the substrate support member further may have at least one common guide member associated therewith; and the substrate support member may be adapted to receive and align both a substrate and the shadow ring. A feature of this aspect of the present invention is that each of the at least one common guide members may be mounted to the substrate support member; and each of the at least one common guide members may be integral with the substrate support member.

So that the manner in which the above recited features, advantages and objects of the present invention are attained and can be understood in detail, a more particular description of the invention, briefly summarized above, may be had by reference to the embodiments thereof which are illustrated in the appended drawings.
It is to be noted, however, that the appended drawings illustrate only typical embodiments of this invention and are therefore not to be considered limiting of its scope, for the invention may admit to other equally effective embodiments.

Figure 1 is a partial cross-sectional view of a conventional shadow ring directly contacting a substrate.

Figure 2 is a partial cross-sectional view of a conventional shadow ring having a purge ring.

Figure 2a is a partial cross-sectional view of the conventional shadow ring shown in Figure 2 showing enlargement of the purge gap between the substrate and the shadow ring after the purge ring has been distorted.

Figure 3 is a partial cross-sectional view of a conventional shadow ring having a common guide member passing through a local cutout in the shadow ring.

Figure 4 is a cross-sectional, side view of a substrate process system according to the present invention.

Figure 5 is a top view of a substrate support member according to the present invention with a substrate placed thereon and the shadow ring removed.

Figure 6 is a cross-sectional view taken along lines 6-6 in Figure 5 showing the alignment and spacing of the shadow ring with respect to the substrate and also showing the purge channel formed in the support member.

Figure 7 is a cross-sectional view taken along lines 7-7 in Figure 5 showing two common guide members received by guide member receiving recesses formed in the lower surface of the shadow ring.

Figure 8 is a detailed partial cross-sectional view of portion 7 of Figure 6.

Figure 9 is a detailed partial cross-sectional view of portion 8 of Figure 7

Referring to Figure 4, the present invention generally provides a device for delivering a flow of purge gas about the periphery of a substrate 14. More particularly, the invention provides a gas delivery apparatus 20 that directs the flow of a purge gas within a process chamber 12 from a gas supply to the bottom of a substrate 14, to the edge 18 of the substrate 14, and about an exclusion zone on the upper side of substrate 14 proximate the edge of the substrate. The invention further provides an improved shadow ring and substrate pedestal, or substrate support member, wherein the substrate pedestal includes at least one wafer guide associated therewith for aligning both the shadow ring and substrate to a common guide member. The shadow ring further includes covered guide member receiving portions for mating with the common guide member and preventing process gasses from flowing therethrough.

Gas delivery apparatus 20 is particularly useful in CVD processing chambers and the following description refers primarily to these CVD processes to facilitate description and understanding. However, it is to be understood that the gas delivery apparatus 20 may have application to other processes, process chambers, and apparatuses, such as PVD and etching apparatuses, and is, therefore, not limited to the precise form described.

Typically, substrates 14 are thin, circular members. Accordingly, they have a center, a periphery wherein each point along the periphery is substantially equidistant from the center, a radial direction characterized by a linear divergence from the center, and tangents, or a tangential direction characterized by a line, or lines, meeting the periphery at a single point. The tangential direction and radial direction are perpendicular to one another. Although substrates are typically circular, the present invention is equally applicable to non-circular substrates, and to substantially circular substrates which include a perimeter flat or flats. Therefore, as used herein, the term radial direction refers to a direction characterized by a linear divergence from the center of the substrate 14.

Still with reference to Figure 4, substrates 14 are generally processed in a process chamber 12 on a support member 30 positioned therein. In the processing of substrates 14, a shadow ring 70 is used to cover the edge of the substrate 14 and, thereby, provide an exclusionary zone on which no deposition is desired. By covering the outer periphery of the substrate 14, the shadow ring 70 helps prevent unwanted deposition of material on the exclusionary zone of the upper surface 16 of the substrate 14 including the edges of the substrate 14, which may be beveled. Although use of shadow ring 70 alone may be partially effective at preventing undesired deposition, a more effective system also incorporates the use of a purge gas directed about the periphery of the substrate 14 which flows about the peripheral edge 18 of the substrate 14 and over its upper surface 16 proximate the edge. Purge gas line 48 is preferably provided in the support member 30 so that a purge gas, such as argon, can be passed into a plurality of purge gas openings 49 in the support member 30. Purge gas openings 49 direct the purge gas to a gas orifice, or purge channel 34, which is preferably in the form of a continuous annular groove formed in the upper surface of support member 30. In this way, the flow of gas may be delivered about the entire periphery of the substrate 14, thereby inhibiting the process gas from coming in contact with the substrate edge surface or the exclusionary zone, and also from flowing to the back side of the substrate 14 and depositing material thereon.

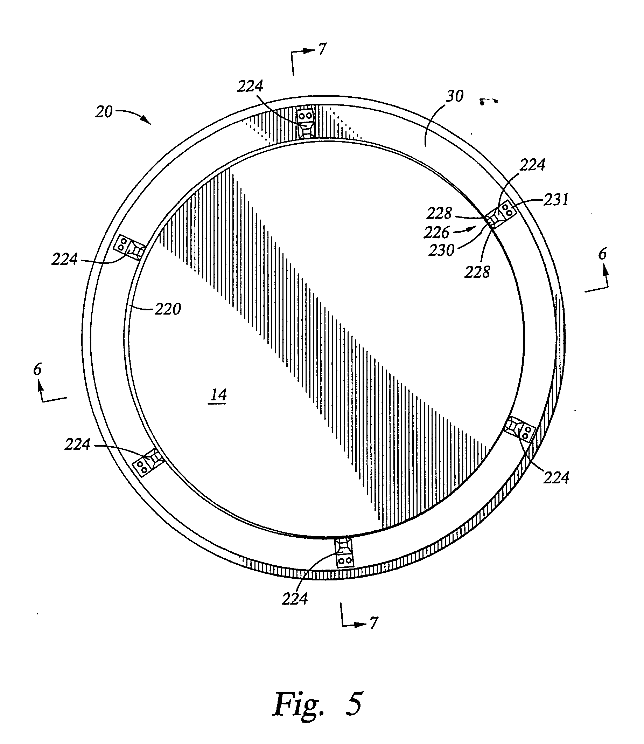

Referring now to Figure 5, substrate 14 is disposed upon support member 30. Guide members 224 are provided on the support member spaced-apart and mounted to the support member about the periphery of the wafer 14 for locating wafer 14 on support member 30. Preferably, the same guide members 224 may operate as both substrate guide pins 224 and shadow ring aligning guides 224. Accordingly, guide members 224 may be referred to as "common guide members" 224. A plurality of common guide members 224 are preferably spaced-apart circumferentially about the periphery of the substrate support member 30 and collectively define the perimeter of a substrate supporting surface. Preferably, the guide members are mounted directly to the support member 30. Accordingly, common guide members 224 may provide substantial alignment of the substrate on the support member 30, while also permitting purge gas to flow over the edge of the substrate proximate the guide members 224.

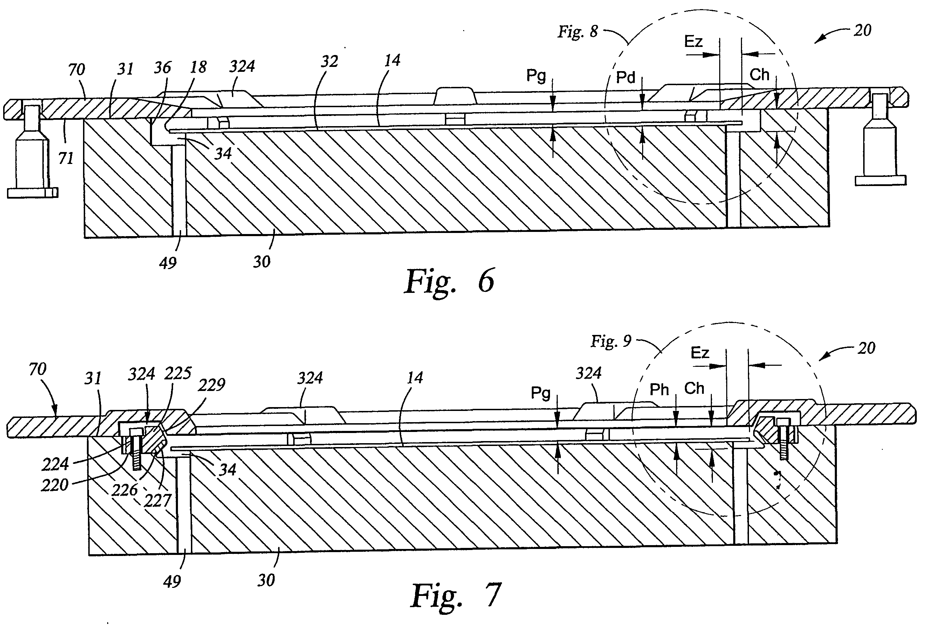

Referring now to Figure 6, support member 30 of gas delivery apparatus 20 is shown taken along section 6-6 of Figure 5. Figure 6 illustrates substrate 14 disposed thereon with shadow ring 70 mounted thereto. Shadow ring 70 preferably has a planar lower surface 71 and is preferably adapted to rest directly on planar upper surface 31 of support member 30 when lowered into the operating position shown in Figure 6. Support member 30 further has a planar substrate receiving surface 32 machined in the upper surface 31 of support member 30 to define a depth Pd below the upper surface 31. Preferably, substrate receiving surface 32 is machined to have a purge depth Pd approximately equal to the sum of the desired substrate thickness and a desired purge gap distance Pg to be provided between the upper surface of the substrate 14 and the under side of the shadow ring 70. Accordingly, purge gap Pg is defined between the upper surface of the substrate 14 and the lower surface 71 of the shadow ring 70.

Purge channel 34, which is preferably an annular groove surrounding substrate receiving surface 32, is preferably machined in the support member 30 immediately outward radially from the substrate recovering surface 32 and is suitably sized to permit substrate 14 to rest on substrate surface 32 and to further provide a radial distance outwardly between the substrate 14 and vertical purge wall 36. Purge channel 34 is preferably machined to a depth greater than purge depth Pd from the upper surface 31 of substrate support member 30 and preferably defines channel height Ch extending from the underside of ring 71 to the base of purge channel 34. Purge gas supply holes 49 are preferably drilled or otherwise machined in the base of support member 30 in fluid communication between purge channel 34 and a source of purge gas at a desired pressure such as a manifold about the distal end of the holes which is supplied with the appropriate gas via a gas panel (not shown). Accordingly, substrate 14 is supported within unitary support member 30 with a purge channel 34 provided therein in fluid communication with a source of purge fluid .

Still with reference to Figure 6, shadow ring 70 is preferably shaped in an annular ring and sized so that the inside diameter of shadow ring 70 is slightly less than the circumference of substrate 14. Accordingly, shadow ring 70 masks an exclusionary zone Ez about the periphery of substrate 14 from receiving process gasses directed generally downwardly towards the upper surface of substrate 14.

Referring now to Figure 7, support member 30 of gas delivery apparatus 20 is shown taken along section 7-7 of Figure 5 to illustrate the positioning of the guide members 224, with respect to the shadow ring 70. Common guide members 224 are shown mounted in recesses 220 preferably machined in and spaced-apart about the upper surface 31 of support member 30. Common guide members 224 are preferably adapted to receive and substantially align both substrate 14 and shadow ring 70. Accordingly, purge gap 34 is substantially uniform about the periphery of substrate 14 and the concentricity of substrate 14 is substantially maintained with respect to shadow ring 70. Guide enclosure portions 324 of shadow ring 70, as described further below, are preferably covered or enclosed to prevent process gasses from passing therethrough and into purge channel 34.

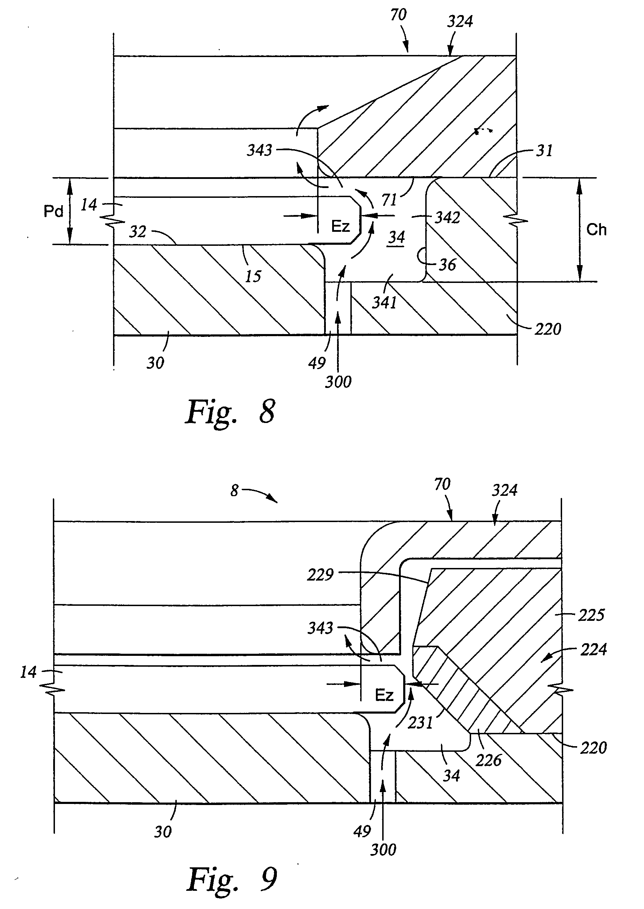

Referring now to Figure 8, that portion of the apparatus shown in Figure 6 is illustrated in greater detail and is illustrative of substantially the entirety of the innermost periphery of shadow ring 70. Purge channel 34 is shown comprising horizontal purge channel 341, vertical purge channel 342, and substrate purge gap 343 provided between the upper surface of substrate 14 and lower surface 71 of shadow ring 70. Purge gap 343 is preferably between .004 inches and .006 inches and is preferably .005 inches in span. Close tolerance for purge gap 343 without contact between shadow ring 70 and substrate 14 is preferably provided by aligning shadow ring 70 vertically by contact between the planar lower surface 71 of shadow ring 70 and the upper planar surface of support member 30. As described further below, lateral alignment of the substrate 14 and shadow ring 70 is provided by common guide members 224 (Figures 5, 7, and 9).

Still with reference to Figure 8, purge gas is provided through purge gas supply holes 49 in support member 30, which are preferably positioned radially inward of the edge of substrate 14 so that purge gas is directed into horizontal purge channel 341 along the lower surface 15 of substrate 14, then into vertical purge channel 342 along the preferably beveled edge of substrate 14, and thereafter into and through purge gap 343 along exclusionary zone Ez (Figure 6) of substrate 14. The direction and orientation of flow of the purge gas is shown by arrows 300. As the purge gas exits purge gap 343, it preferably flows around the inside edge of shadow ring 70 and generally follows the surface of shadow ring 70 so as not to interfere with the process gasses directed generally towards the surface of substrate 14 radially inward of exclusionary zone Ez (Figure 6) of substrate 14. The flow of purge gas over the surface of shadow ring 70 is caused by vacuum ports (not shown) around the perimeter of the process chamber 12. Preferably, the inside edge of shadow ring 70 is aerodynamically shaped to facilitate purge gas flow there along.

Referring now to Figure 9, that portion of the apparatus from Figure 7 is shown in detail and is illustrative of portions of shadow ring 70, which are adapted to receive common guide members 224. In one embodiment, common guide member 224 is shown mounted in recess 220 of support member 30 and may comprise a first, or shadow ring receiving element 225 and a second, or substrate receiving element 226. First element 225 may preferably be a suitably hard material such as stainless steel and is primarily adapted to contact shadow ring 70 during alignment thereof. Second element 226 is primarily adapted to contact substrate 14 during alignment thereof. Accordingly, second element 226 may preferably be an element non-reactive with the deposition chemistry with suitable characteristics for minimizing particle generation during such contact.

Referring to Figures 5, 7 and 9, common guide member 224 is preferably mounted or otherwise affixed to substrate support member 30 by bolts or other suitable fasteners. Preferably, common guide member 224 includes an inside surface, which preferably includes an upper angled surface 229 adapted to mate with the underside lower of the shadow ring 70 to align the shadow ring 70 over the substrate receiving surface 32 of substrate support member 30. A lower angled surface 231 may also be provided on the inside surface of common guide member 224 adapted to mate with and receive and align the substrate 14 on the substrate receiving surface 32 of substrate support member 30.

Referring again to Figure 4, a typical process chamber 12 defined by an outer body 13 is shown. The chamber 12 may be part of a vacuum processing system having a plurality of process chambers 12 connected to a central transfer chamber. The process chamber 12 houses the support member 30 that may take the form of a pedestal or susceptor mounted on a generally vertically oriented shaft 38. The support member 30 serves to support a substrate 14 on its flat upper surface 32. Typically, the support member comprises a block of metal, *e.g*., aluminum, that has a resistance heater embedded therein. However, the support member may be formed of other materials such as ceramic.

Figure 4 also illustrates a substrate lifting finger 200 received in the finger aperture passing through the body of the support member 30. Typically, the process chamber 12 would include three or four such lifting fingers 200. These lifting fingers 200 operate to lift the substrate 14 clear of the upper surface 32 of the support member 30 after processing. This removal of the substrate 14 is achieved by means of a conventional process chamber robot arm (not shown) which enters the process chamber 12 through a slit valve opening. The same robot arm is also used to insert the substrates 14 into the process chamber 12. The lifting fingers 200 are movable vertically under action of a secondary motion actuator 202 of which only the upper portion is shown in Figure 4.

A motion actuator interconnected to the support member 30 is adapted to move the support member 30 vertically within the process chamber 12 alternately between a first, lowered position and a second, raised position where the process step is performed. Shadow ring 70 rests directly on support member 30 in the second, raised position where the process step is performed. Shadow ring 70 may also be raised to a second, raised position using shadow ring lifting member 210 for insertion and removal of substrate 14.

In operation, the substrate 14 is placed onto the upper surface 32 of the support member 30 as follows. Shadow ring lifting member 210 raises shadow ring 70 to its second, raised position. The robot arm then inserts the substrate 14 into the process chamber 12 through the slit valve opening to position the substrate 14 above the support member 30. The secondary motion actuator (not shown) raises the lifting fingers 200, which extend through finger apertures in the support member 30, into contact with the substrate 14 and lifts the substrate 14 from the robot arm supporting the substrate 14 intermediate the first and second positions of the support member 30. The robot arm is then retracted from the process chamber 12. Next, the motion actuator lifts the support member 30 from the first position, past the top of the lifting fingers 200, to the second position. This motion of the support member 30 lifts the substrate 14 from the lifting fingers 200. Performing these steps in reverse order operates to complete a transfer of the substrate 14 from the support member 30 to the robot arm and from the process chamber 12. In a particular embodiment, support member 30 may also remain stationary as shadow ring 70 is raised by shadow ring lifting member 210. In other embodiments, support member 30 may be lowered and raised as described above and shadow ring lifting member 70 rests statically on shadow ring lifting member 210.

During processing, the support member 30 may move upward into a raised position lifting the shadow ring 70 from resting on the shadow ring lifting member 210. The shadow ring 70 rests on the upper surface 31 of the support member 30 and supports the shadow ring 70 above the upper surface of the substrate 14. The shadow ring 70 defines a circular upper aperture 82 therethrough. The diameter of the upper aperture 82 may be slightly less than the outer diameter of the substrate 14 to form an exclusionary zone on the substrate 14. However, new processes may require no overhang of the shadow ring 70 over the substrate 14.

As substrate 14 is placed on substrate support member 30, it is centered and aligned thereon by common guide members 324 spaced there around as described above. As shadow ring 70 is lowered to rest on upper support surface 31 of substrate support member 30 or, alternatively, as support member 30 is raised to lift shadow ring 70 from shadow ring lifting members 210, shadow ring 70 is centered and aligned concentrically with substrate 13 by the same common guide members 324 that centered and aligned substrate 14. The common guide member 224 may be mounted to substrate support member 30 or may be integral with substrate support member 30.
While the foregoing is directed to the preferred embodiment of the present invention, other and further embodiments of the invention may be devised without departing from the basic scope thereof, and the scope thereof is determined by the claims which follow.

## Claims

1. An alignment apparatus for concentrically aligning a shadow ring and substrate on a substrate support member in a substrate processing system, comprising:
a support member;
one or more common guide members adapted to receive both an edge of the substrate and a guide enclosure portion of the shadow ring;
a shadow ring defining one or more recesses on a lower surface thereof to receive the one or more guide members; and
the guide enclosure portion of the shadow ring being shielded from process gasses directed towards the shadow ring from above the shadow ring.

2. An alignment apparatus as claimed in claim 1, wherein each of the at least one guide enclosure portions of the shadow ring include at least one guide member recess formed in the lower surface of the shadow ring and adapted to receive at least one common guide member therein.

3. An alignment apparatus as claimed in claim 1 or claim 2, wherein the shadow ring has an aerodynamically shaped upper surface proximate the or each of the guide enclosure portions.

4. An alignment apparatus as claimed in any of claims 1 to 3, wherein a continuous purge gap is maintained between the shadow ring and the substrate during processing.

5. An alignment apparatus as claimed in claim 4, wherein the purge gap is maintained by supporting the shadow ring on the substrate support member.

6. An alignment apparatus as claimed in claim 4 or claim 5, wherein there is no separate purge ring attached to the substrate support member for supporting the shadow ring.

7. An alignment apparatus as claimed in any of claims 1 to 6, wherein the substrate support member is of unitary construction.

8. A substrate alignment and shielding apparatus, comprising:
(a) a substrate support member, comprising:
a substrate support portion defined thereon,
an upper surface formed about the periphery thereof, an annular purge gap formed therein, and
one or more common guide member associated therewith; and
(b) a shadow ring adapted to rest on the upper surface of the substrate support member.

9. A substrate alignment and shielding apparatus as claimed in claim 8, wherein each of the at least one common guide members is mounted to the substrate support member.

10. A substrate alignment and shielding apparatus as claimed in claim 9, wherein each of the at least one common guide members is integral with the substrate support member.

11. A method of aligning a substrate and a shadow ring with one another in a substrate process system, comprising the steps of:
providing a substrate support member having a purge gap formed therein, having a substrate supporting portion therein, and having an upper surface thereon;
the substrate support member including at least one common guide member proximate the purge gap formed therein and adapted to receive and align both the substrate and the shadow ring;
lowering the substrate on the substrate support member proximate the common guide members so that, as the substrate is lowered, the substrate is aligned within the common guide members; and
lowering the shadow ring on the upper surface of the substrate support member while maintaining general alignment between the common guide members and guide member recesses formed in the lower surface of the shadow ring.

12. A substrate processing system, comprising:
a process chamber;
a substrate support member disposed within the process chamber having a substrate support potion machined therein;
the substrate support member having an upper surface formed about the periphery thereof;
a shadow ring adapted to rest on the upper surface of the substrate support member;
the substrate support member further having an annular purge gap formed therein;
the substrate support member further having at least one common guide member associated therewith; and
the substrate support member is adapted to receive and align both a substrate and the shadow ring.

13. A substrate processing system as claimed in claim 12, wherein each of the at least one common guide members is mounted to the substrate support member.

14. A substrate alignment and shielding apparatus as claimed in claim 13, wherein each of the at least one common guide members is integral with the substrate support member.
